# EUROPEAN PATENT SPECIFICATION

(11) **EP 4 450 675 B1**
(45) Date of publication and mention of the grant of the patent: **09.09.2026**
(21) Application number: 21967978.4
(22) Date of filing: 16.12.2021
(51) Int. Cl.: H01J 37/34, C23C 14/35, C23C 14/14

(54) **TARGET MADE OF MAGNETIC MATERIAL FOR MAGNETRON SPUTTERING**
TARGET AUS MAGNETISCHEM MATERIAL FÜR DIE MAGNETRON-ZERSTÄUBUNG
CIBLE FAITE DE MATÉRIAU MAGNÉTIQUE POUR PULVÉRISATION PAR MAGNÉTRON

(43) Date of publication of application: 23.10.2024
(73) Proprietor: Naco Technologies, SIA, 1005 Riga (LV)
(72) Inventor: MITIN, Valery, deceased (RU); NAZAROVS, Pavels, 1029 Riga (LV); LENCEVSKIS, Vladimirs, 1035 Riga (LV); KOVALENKO, Vladimirs, 1069 Riga (LV)
(74) Representative: Vitina, Maruta
(86) International application number: PCT/IB2021/061821
(87) International publication number: WO 2023/111650

(56) References cited:
- CN-A- 1 397 660
- CN-A- 111 996 504
- CN-A- 111 996 504
- RU-C- 1 725 574
- US-A- 4 569 746
- US-A- 4 810 347
- US-A1- 2005 034 980
- US-B1- 6 623 610

## Description

The invention relates to the field of PVD (Physical Vapor Deposition) technology for obtaining coatings, in particular, to the deposition of protective and functional coatings from magnetic materials, for example iron, nickel, cobalt and other ferromagnets and ferrimagnets on parts and mechanisms by the magnetron method and more particularly to the structure of a target made of magnetic material.

In a traditional magnetron, it is impossible to sputter magnetic material like a conventional material due to the magnetic field shunting by the target from the poles of the magnetron magnetic system. For this reason, there is no magnetic field above the target surface and no magnetic trap is formed to retain the electronic component of the plasma in the sputtering zone. In this case, magnetron discharge over the surface of the target is impossible and sputtering of its material does not occur.

Some design solutions are known that allow to some extent to carry out the process of sputtering a target from a magnetic material using a magnetron.

The design of the target with protruding magnets [US 6623610B1] is known, which are mounted on the sputtering surface of the target and create a magnetic trap above it. The surface of the magnets is protected from sputtering by a film made of a material similar to the target material. The main disadvantages of the sputtering process of such a target are: poor cooling of protruding pole magnets (as a result, low sputtering rate); ineffective protection of pole magnets from sputtering and low service life of the sputtering material - small target thickness. US 2005/034980 A1 discloses a ferromagnetic target having three parts, i.e. a primary target separated and surrounded by an outer auxiliary target and by an inner auxiliary target. A gap separates the primary target from each of the auxiliary targets. Below each of the auxiliary targets are located magnetic means, comprising magnetic poles. The auxiliary targets are raised above the plane of the primary target. The relative position of the magnetic poles with respect to the three different target parts enables the magnetic field to be conducted across in field lines, to produce a closed S field between the auxiliary targets. The profile of the auxiliary targets may be tapered so as to minimise the extent of their erosion by sputtering.

The closest to the proposed invention is a device for sputtering a magnetic target [CN111996504A], in which the target consists of separate elements: a central rod, which is the inner pole of the main magnetic system of the magnetron; a peripheral ring, which is the outer pole of the peripheral pole of the main magnetic system of the magnetron; the sputterable portion of the target, located between the outer poles and limited from them by gaps, in which elements of ceramic non-magnetic material are installed. The central and peripheral poles rise above the target surface.

The disadvantages of the known design solution are the presence of a high-temperature insulating outer ring and a high-temperature insulating inner ring, since they are difficult to manufacture and operate, as well as insufficient spraying speed and low uniformity of the spraying zone.

The technical problem solved by the proposed invention is to simplify the design of the target by eliminating the insulating parts, as well as to increase the sputtering rate and improve the uniformity of the sputtering zone.

In a target made of magnetic material comprising a sputterable portion of the target, a peripheral protruding pole, a central protruding pole and a cooled base, the sputterable portion of the target and the protruding poles being made of the same magnetic material, according to the proposed invention, the sputterable portion of the target, which has a double-sided taper at an angle in the range of 20-30 ° on the outer side surface and at an angle in the range of 20-30 ° on the inner side surface, is enclosed without a visible gap in the free landing between the peripheral protruding pole and the central protruding pole, which protrude above the surface of the sputterable portion of the target so as to provide residual induction of the magnetic field in the range of 0.05-0.085 T on the upper end surfaces of the peripheral protruding pole and the central protruding pole.

Since the sputterable portion of the target is enclosed without a visible gap in the free landing between the peripheral protruding pole and the central protruding pole, there are no rings or other elements made of non-magnetic material that complicate the design of the target. The absence of a visible gap ensures the mutual alignment of the structural elements of the proposed target.

At an angle of taper of the sputterable portion of the target of less than 20 °, the magnetic field will be shunted, and at an angle of more than 30 °, the active surface of the sputterable portion of the magnetic target will be reduced.

The residual induction of the magnetic field in the range of 0.05-0.085 T on the upper end surfaces of the peripheral protruding pole and the central protruding pole is the optimal value for maintaining the magnetron discharge.

Since the protruding poles are slightly sputtering during the operation of the magnetron, so that the applied coating is not contaminated, the protruding poles are made of the same magnetic material as the sputtering part of the target.

The peripheral protruding pole on the outer side from the end preferably has a rounding with a radius R of at least 5 mm, and on the inner side protruding above the sputterable portion of the target has a bevel at an angle within 30-40, and the central pole also has a bevel within 30-40, wherein both said bevels are starting at the level of the upper surface of the sputterable portion of the target. The outer rounding of the peripheral protruding pole prevents the occurrence of a parasitic discharge at the edge and thereby reduces the erosion of this pole, and the bevels at the protruding poles within 30-40° provide a large angle of dispersion of the sprayed magnetic material.

The ratio of the height of the peripheral protruding pole and the central protruding pole protruding above the surface of the sputterable portion of the target to the thickness of the sputterable portion of the target preferably is 1.5-1.7. This ratio provides residual induction of the magnetic field of at least 0.05-0.085 T on the upper end surfaces of the peripheral protruding pole and the central protruding pole.

The sputterable portion of the target and the protruding poles preferably are bonded by soldering to the cooled base made of a thin sheet, wherein the thermal conductivity of the material of the cooled base is not lower than 250 W/m·K. This ensures effective cooling of the target. The sputterable portion of the target and the protruding poles are bonded by soldering to the cooled base for mutual fixation.

The thickness of the thin sheet of the cooled base preferably is 0.3-1.5 mm. With a sheet thickness of less than 0.3 mm, there is insufficient rigidity of the structure, and with a thickness of more than 1.5 mm, the magnitude of the magnetic field induction over the sputterable portion of the target decreases.

The invention is explained in more detail below with reference to the accompanying drawings, wherein is shown:
On Fig. 1 - a target made of a round-shaped magnetic material (a section in axonometry);
On Fig. 2 - a sputterable portion of the target with bilateral asymmetric taper (a section);
On Fig. 3 - a target made of a magnetic material installed above the magnetron magnetic system (a section);
On Fig. 4 - a sputterable portion of the target with bilateral symmetric taper (a section);
On Fig. 5 - a target made of a rectangular-shaped magnetic material (a section in axonometry).

The present invention is explained by examples of its specific implementation.

### Embodiment 1.

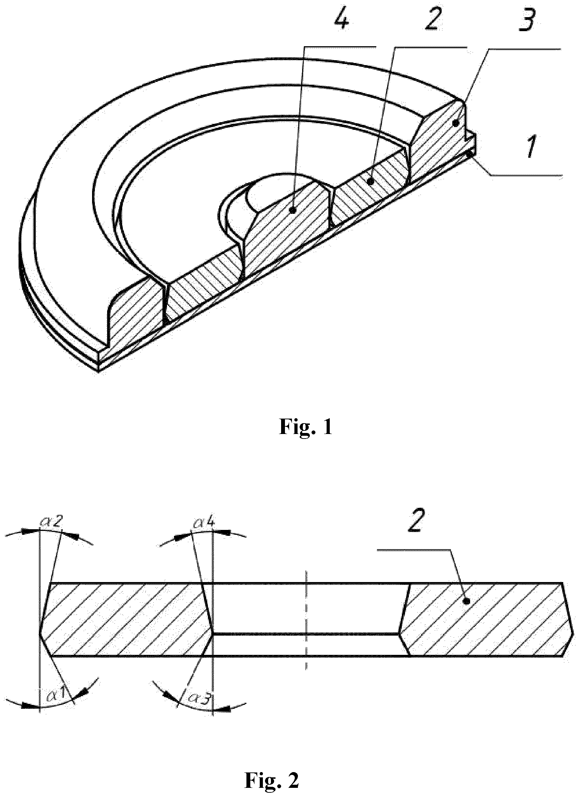

A target made of a round-shaped magnetic material (Fig. 1) intended for magnetron sputtering includes a sputterable portion 2 of the target in the form of a ring, a peripheral protruding pole 3 and a central protruding pole 4. The sputterable portion 2 of the target and the protruding poles 3, 4 are made of nickel. The sputterable portion 2 of the target (FIG. 2), which has a double-sided asymmetric taper at an angle α₁ and α₂ on the outer side surface, equal to 30° and 20°, respectively, and at an angle α₃ and α₄ on the inner side surface, equal to 30° and 20°, respectively, is enclosed without a visible gap in the free landing between the peripheral protruding pole 3 and the central protruding pole 4. The peripheral protruding pole 3 on the outer side from the end has a rounding with a radius R equal to 5 mm, and on the inner side protruding above the sputterable portion 2 of the target has a bevel at an angle β₁ equal to 40°. The central protruding pole 4 also has a similar bevel β₂ equal to 40°, wherein the beginning of both said bevels is at the level of the upper surface of the sputterable portion 2 of the target.

The thickness of the sputterable portion 2 of the target is 10 mm, and the height of the peripheral protruding pole 3 and the central protruding pole 4 protruding above the surface of the sputterable portion 2 of the target is related to the thickness of the sputterable portion 2 of the target as 1.5. This provides residual induction of the magnetic field of 0.08 T on the upper end surfaces of the peripheral protruding pole 3 and the central protruding pole 4. The sputterable portion 2 of the target and the protruding poles 3, 4 are mounted on a cooled base 1 made of a 0.5 mm thick copper sheet and bonded by soldering.

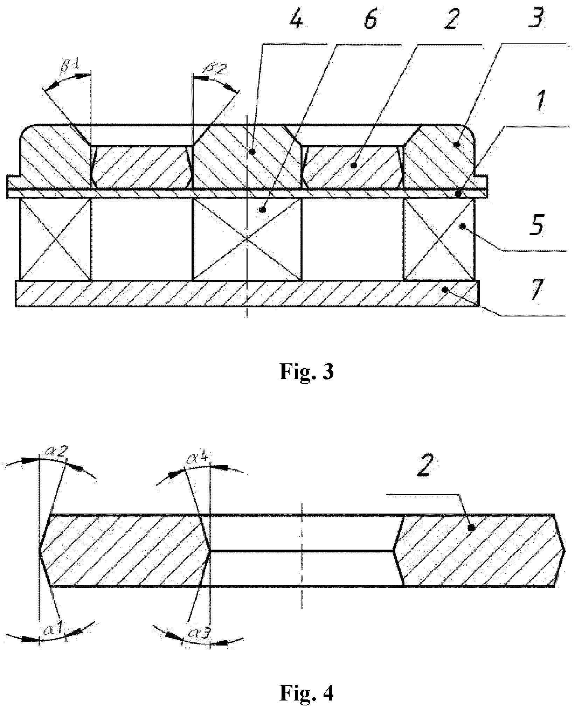

The dimensions and configuration of the target from the magnetic material are selected in accordance with the magnetic system of the magnetron in such a way that the magnetic field of the magnetic system of the magnetron provides residual induction of the magnetic field on the upper end surfaces of the protruding poles 3 and 4 in the range of 0.05-0.085 T. A target made of a magnetic material is installed in a mirror image in relation to the magnetic system of the magnetron. The sputterable portion 2 of the target is installed over the gap between the magnetic poles of the magnetic system of the magnetron 5 and 6 located on the magnetic circuit 7, the central protruding pole 4 of the target - over the central magnetic pole 6 of the magnetic system, and the peripheral protruding pole 3 of the target - over the peripheral pole 5 of the magnetic system (Fig. 3).

A target made of a magnetic material works as follows.

By touching the sputterable portion 2 of the target to the peripheral protruding pole 3 and central protruding pole 4 only along the line, the magnetic field shunting is insignificant, therefore, when the magnetron operates above the surface of the sputterable portion 2 of the target, there is a longitudinal intense magnetic field, the induction value of which exceeds 0.05 T. When a voltage is applied to the target made of a magnetic material, which is a cathode, a magnetic trap for electrons arises above its surface due to the intersection of the magnetic and electric fields, the ionization efficiency increases and a magnetron discharge occurs (at the corresponding pressure of the working gas in the sputtering chamber). As a result, the sputterable portion 2 of the target is sputtered. As the sputterable portion 2 of the target is worn out, it becomes thinner.

The thickness of the sputterable portion 2 of the target, equal to 10 mm, provides a large resource of the sputterable material, and the bevels on the surfaces of the protruding poles 3, 4 provide a large dispersion of the sputterable material and, accordingly, the sputterable material is sprayed over an area comparable to a traditional magnetron, and a high degree of uniformity of the coating is ensured.

The connection of the protruding poles and the sputterable portion of the target with the target base by bonding provides a high heat sink, which allows operating at power densities up to 200 W/cm², thereby achieving a high rate of sputtering of the sputterable portion 2 of the target.

It is significant that the sputterable portion 2 of the target is replaced as it is worn out, and the protruding poles 3, 4 can be used repeatedly.

### Embodiment 2.

A target made of a round-shaped magnetic material (Fig. 1) includes a sputterable portion 2 of the target, a peripheral protruding pole 3 and a central protruding pole 4. The sputterable portion 2 of the target and the protruding poles 3, 4 are made of Terfenol-D (TbₓDy₁₋ₓFe₂, x≈0.3). The sputterable portion 2 of the target, which has a double-sided symmetrical taper at an angle α₁ and α₂ on the outer side surface of 30° and at an angle α₃ and α₄ on the inner side surface of 30° (FIG. 4) is enclosed without a visible gap in the free landing between the peripheral protruding pole 3 and the central protruding pole 4. The bevels at the protruding poles are 30°. The height of the peripheral protruding pole 3 and the central protruding pole 4 protruding above the surface of the sputterable portion 2 of the target is related to the thickness of the sputterable portion 2 of the target as 1.7, wherein the thickness of the sputterable portion 2 of the target is 10 mm. This provides residual induction of the magnetic field of 0.07 T on the upper end surfaces of the peripheral protruding pole 3 and the central protruding pole 4. The sputterable portion 2 of the target and the protruding poles are mounted on a cooled base 1 made of a 1.0 mm thick copper sheet and bonded by soldering.

A target made of a magnetic material works in the same way as described in Embodiment 1.

### Embodiment 3.

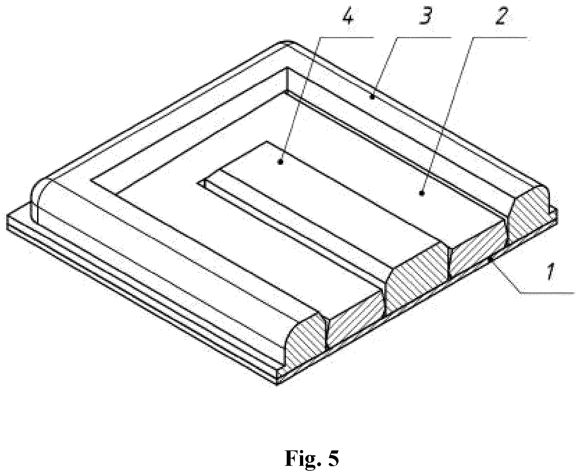

A target made of a rectangular-shaped magnetic material (Fig. 5) includes a sputterable portion 2 of the target, a peripheral protruding pole 3 and a central protruding pole 4. The sputterable portion 2 of the target and the protruding poles 3, 4 are made of ARMCO Pure Iron. The sputterable portion 2 of the target, which has a double-sided symmetrical taper at an angle α₁ and α₂ on the outer side surface, equal to 30°, and at an angle α₃ and α₄ on the inner side surface, equal to 30°, is enclosed without a visible gap in the free landing between the peripheral protruding pole 3 and the central protruding pole 4. The sputterable portion 2 of the target is composite. The bevels at the protruding poles are 40°. The height of the peripheral protruding pole 3 and the central protruding pole 4 protruding above the surface of the sputterable portion 2 of the target is related to the thickness of the sputterable portion 2 of the target as 1.5, wherein the thickness of the sputterable portion 2 of the target is 8 mm. This provides residual induction of the magnetic field of 0.06 T on the upper end surfaces of the peripheral protruding pole 3 and the central protruding pole 4. The sputterable portion 2 of the target and the protruding poles are mounted on a cooled base 1 made of a 0.50 mm thick copper sheet and bonded by soldering.

A target made of a magnetic material works in the same way as described in Embodiment 1.

## Claims

1. A target made of a magnetic material for magnetron sputtering comprising a sputterable portion (2), of the target, a peripheral protruding pole (3), a central protruding pole (4) and a cooled base (1), the sputterable portion (2) of the target and the protruding poles (3, 4) being made of the same magnetic material,
**characterized in that** the sputterable portion (2) of the target, which has a double-sided taper at an angle (α₁ and α₂) in the range of 20-30° on the outer side surface and at an angle (α₃ and α₄) in the range of 20-30° on the inner side surface, is enclosed without a visible gap in the free landing between the peripheral protruding pole (3) and the central protruding pole (4), which protrude above the surface of the sputterable portion (2) of the target so as to provide residual induction of the magnetic field in the range of 0.05-0.085 T on the upper end surfaces of the peripheral protruding pole (3) and the central protruding pole (4).

2. The target according to claim 1, wherein the peripheral protruding pole (3) on the outer side from the end has a rounding with a radius R of at least 5 mm, and on the inner side protruding above the sputterable portion (2) of the target has a bevel at an angle (β₁) within 30-40°, and the central protruding pole (4) also has a bevel (β₂) within 30-40°, wherein both said bevels are starting at the level of the upper surface of the sputterable portion of the target (2).

3. The target according to claim 1, wherein the ratio of the height of the peripheral protruding pole (3) and the central protruding pole (4) protruding above the surface of the sputterable portion (2) of the target to the thickness of the sputterable portion (2) of the target is 1.5-1.7.

4. The target according to claim 1, wherein the sputterable portion of the target (2) and the protruding poles (3, 4) are bonded by soldering to the cooled base (1) made of a thin sheet, wherein the thermal conductivity of the material of the cooled base (1) is not lower than 250 W/ (m·K).

5. The target according to claim 3, wherein the thickness of the thin sheet of the cooled base (5) is 0.3-1.5 mm.

## Patentansprüche

1. Target aus magnetischem Material für Magnetron-Sputtern, bestehend aus einem sputterbaren Bereich (2), einem hervorstehenden Randpol (3), einem hervorstehenden Mittelpol (4)) und einem gekühlten Sockel (1), wobei der sputterbare Bereich (2) und die hervorstehenden Pole (3, 4) aus demselben magnetischen Material bestehen,
**dadurch gekennzeichnet,**
**dass** der sputterbare Bereich (2) mit einer beidseitigen Verjüngung um einen Winkel (α₁ und α₂) von 20-30° an der Außenseite und einen Winkel (α₃ und α₄) von 20-30° an der Innenseite spaltfrei zwischen dem hervorstehenden Randpol (3) und dem hervorstehenden Mittelpol (4) liegt, die über die Oberfläche des sputterbaren Bereichs (2) hinausragen, um eine Restinduktion des Magnetfelds im Bereich von 0,05-0,085 T an den oberen Endflächen des hervorstehenden Randpol (3) des und hervorstehenden Mittelpol (4) zu erzeugen.

2. Target nach Anspruch 1, wobei der hervorstehenden Randpol (3) auf der Außenseite am Ende eine Abrundung mit einem Radius R von mindestens 5 mm aufweist und auf der Innenseite des über den sputterbaren Bereich (2) des Targets hinausragenden Teil eine Fase mit einem Winkel (β₁) von 30-40° aufweist, und der zentrale hervorstehende Mittelpol (4) ebenfalls auf der Außenseite eine Fase (β₂) von 30-40° aufweist, wobei beide Fasen auf Höhe der Oberseite des sputterbaren Bereichs des Targets (2) beginnen.
und auf der Innenseite des über den besprühten Teil (2) hinausragenden Teils des Ziels befindet sich eine Abschrägung mit einem Winkel (β1) innerhalb von 30-40°,

3. Target nach Anspruch 1, wobei das Verhältnis der Höhe des des hervorstehenden Randpols (3) und des hervorstehenden Mittelpols (4), die über die Oberfläche des sputterbaren Bereichs des Targets (2) hinausragen, zur Dicke des sputterbaren Bereichs (2) des Targets 1,5-1,7 beträgt.

4. Target nach Anspruch 1, wobei der sputterbare Bereich des Targets (2) und die hervorstehenden Pole (3, 4) durch Löten mit der aus einem dünnen Blech bestehenden, gekühlten Basis (1) verbunden sind, wobei die Wärmeleitfähigkeit des Materials der gekühlten Basis (1) mindestens 250 W/(m·K) beträgt.

5. Target nach Anspruch 3, wobei die Dicke des dünnen Blechs der gekühlten Basis (5) 0,3-1,5 mm beträgt.

## Revendications

1. Cible en matériau magnétique pour pulvérisation magnétronique comprenant une partie pulvérisable (2), un pôle périphérique saillant (3), un pôle central saillant (4) et une base refroidie (1), la partie pulvérisable (2) et les pôles saillants (3, 4) étant constitués du même matériau magnétique,
**caractérisée en ce que** la partie pulvérisable (2) de la cible, présentant une conicité double face sous l'angle (α₁ et α₂) compris entre 20 et 30° sur sa face externe et sous l'angle (α₃ et α₄) compris entre 20 et 30° sur sa face interne, est enfermée sans interstice visible dans la zone de contact libre entre le pôle périphérique saillant (3) et le pôle central saillant (4), qui dépassent de la surface de la partie pulvérisable (2) de la cible afin de générer une induction magnétique résiduelle de l'ordre de 0,05-0,085 T sur les surfaces supérieures des extrémités des pôles saillants périphériques (3) et centraux (4).

2. Cible selon la revendication 1, dans laquelle le pôle saillant périphérique (3) présente, sur sa face extérieure, à l'extrémité, un arrondi de rayon R d'au moins 5 mm et, sur sa face intérieure dépassant la partie pulvérisable (2) de la cible, un biseau sous l'angle (β₁) compris entre 30 et 40°, et le pôle central (4) présente également un biseau (β₂) compris entre 30 et 40°, ces deux biseaux partant du niveau de la surface supérieure de la partie pulvérisable de la cible (2).

3. Cible selon la revendication 1, **caractérisée en ce que** le rapport entre la hauteur du pôle saillant périphérique (3) et du pôle saillant central (4) dépassant de la surface de la partie pulvérisable de la cible (2) et l'épaisseur de cette partie pulvérisable (2) est compris entre 1,5 et 1,7.

4. Cible selon la revendication 1, **caractérisée en ce que** la partie pulvérisable de la cible (2) et les pôles saillants (3, 4) sont liés par brasage à la base refroidie (1) constituée d'une feuille mince, la conductivité thermique du matériau de la base refroidie (1) étant supérieure ou égale à 250 W/(m·deg).

5. Cible selon la revendication 3, **caractérisée en ce que** l'épaisseur de la feuille mince de la base refroidie (5) est comprise entre 0,3 et 1,5 mm.
